# EUROPEAN PATENT APPLICATION

(11) **EP 4 811 959 A1**
(43) Date of publication of application: **23.09.2026**
(21) Application number: 25203027.5
(22) Date of filing: 18.09.2025
(51) Int. Cl.: H10D 30/67

(54) **SEMICONDUCTOR DEVICE AND SEMICONDUCTOR MEMORY DEVICE**

(30) Priority: 18.03.2025 JP 2025044095
(71) Applicant: Kioxia Corporation, Tokyo 108-0023 (JP)
(72) Inventor: Kamiyama, Akinori, Tokyo, 108-0023 (JP); Haga, Kenichi, Tokyo, 108-0023 (JP); Ikeda, Keiji, Tokyo, 108-0023 (JP)
(74) Representative: Marks & Clerk LLP

(57) **Abstract**

A semiconductor device of embodiments includes a first electrode, a second electrode, an oxide semiconductor layer provided between the first electrode and the second electrode, a gate electrode surrounding the oxide semiconductor layer, and a gate insulating layer. The gate electrode includes a first layer containing a first material having a first work function, a second layer provided on the first electrode side with respect to the first layer and containing a second material having a second work function, and a third layer provided on the second electrode side with respect to the first layer and containing a third material having a third work function. When the first conductive type is n-type, the second work function is smaller than the first work function, and the third work function is smaller than the first work function.

## Description

### CROSS-REFERENCE TO RELATED APPLICATION

This application is based upon and claims the benefit of priority from Japanese Patent Application No. 2025-044095, filed on March 18, 2025.

### FIELD

Embodiments described herein relate generally to a semiconductor device and a semiconductor memory device.

### BACKGROUND

An oxide semiconductor transistor in which a channel is formed in an oxide semiconductor layer has an excellent characteristic that the channel leakage current during off operation is very small. For this reason, for example, the oxide semiconductor transistor can be applied as a switching transistor of a memory cell in a dynamic random access memory (DRAM).

### BRIEF DESCRIPTION OF THE DRAWINGS

Fig. 1 is a schematic cross-sectional view of a semiconductor device according to a first embodiment;
Fig. 2 is a schematic cross-sectional view of the semiconductor device according to the first embodiment;
Fig. 3 is a schematic cross-sectional view of a semiconductor device according to a comparative embodiment;
Fig. 4 is a schematic cross-sectional view of a semiconductor device according to a further embodiment of the first embodiment;
Fig. 5 is an equivalent circuit diagram of a semiconductor memory device according to a second embodiment; and
Fig. 6 is a schematic cross-sectional view of the semiconductor memory device according to the second embodiment.

### DETAILED DESCRIPTION

A semiconductor device of embodiments includes: a first electrode; a second electrode; an oxide semiconductor layer provided between the first electrode and the second electrode; a gate electrode surrounding the oxide semiconductor layer; and a gate insulating layer provided between the gate electrode and the oxide semiconductor layer. The oxide semiconductor layer includes: a first region of a first conductive type facing the gate electrode; a second region of the first conductive type provided between the first region and the first electrode; and a third region of the first conductive type provided between the first region and the second electrode. The gate electrode includes: a first layer containing a first material having a first work function; a second layer provided on a first electrode side with respect to the first layer and containing a second material having a second work function; and a third layer provided on a second electrode side with respect to the first layer and containing a third material having a third work function. When the first conductive type is n-type, the second work function is smaller than the first work function, and the third work function is smaller than the first work function. When the first conductive type is p-type, the second work function is larger than the first work function, and the third work function is larger than the first work function.

Hereinafter, embodiments will be described with reference to the diagrams. In addition, in the following description, the same or similar members and the like are denoted by the same reference numerals, and the description of the members and the like once described may be omitted as appropriate.

In addition, in this specification, the terms "on", "below", "upper", "lower", "upward", and "downward" may be used for convenience. "On", "below", "upper", "lower", "upward", and "downward" are terms that only indicate the relative positional relationship in the diagrams, and are not terms that define the positional relationship with respect to gravity.

The qualitative analysis and quantitative analysis of the chemical composition of members forming the semiconductor device and the semiconductor memory device in this specification can be performed by, for example, secondary ion mass spectrometry (SIMS), energy dispersive X-ray spectroscopy (EDX), and Rutherford back-scattering spectroscopy (RBS). In addition, when measuring the thickness of each member forming the semiconductor device and the semiconductor memory device, a distance between members, a crystal particle size, and the like, it is possible to use, for example, a transmission electron microscope (TEM).

The work function of each member forming the semiconductor device and the semiconductor memory device in this specification can be specified as an inherent value of a material contained in the member, for example, if the material is specified. In addition, the work function of each member forming the semiconductor device and the semiconductor memory device in this specification can be measured using, for example, a Kelvin Probe Force Microscopy (KPFM) or X-ray Photoelectron Spectroscopy (XPS).

### (First Embodiment)

A semiconductor device according to a first embodiment includes: a first electrode; a second electrode; an oxide semiconductor layer provided between the first electrode and the second electrode; a gate electrode surrounding the oxide semiconductor layer; and a gate insulating layer provided between the gate electrode and the oxide semiconductor layer. The oxide semiconductor layer includes: a first region of a first conductive type facing the gate electrode; a second region of the first conductive type provided between the first region and the first electrode; and a third region of the first conductive type provided between the first region and the second electrode. The gate electrode includes: a first layer containing a first material having a first work function; a second layer provided on the first electrode side with respect to the first layer and containing a second material having a second work function; and a third layer provided on the second electrode side with respect to the first layer and containing a third material having a third work function. When the first conductive type is n-type, the second work function is smaller than the first work function, and the third work function is smaller than the first work function. When the first conductive type is p-type, the second work function is larger than the first work function, and the third work function is larger than the first work function.

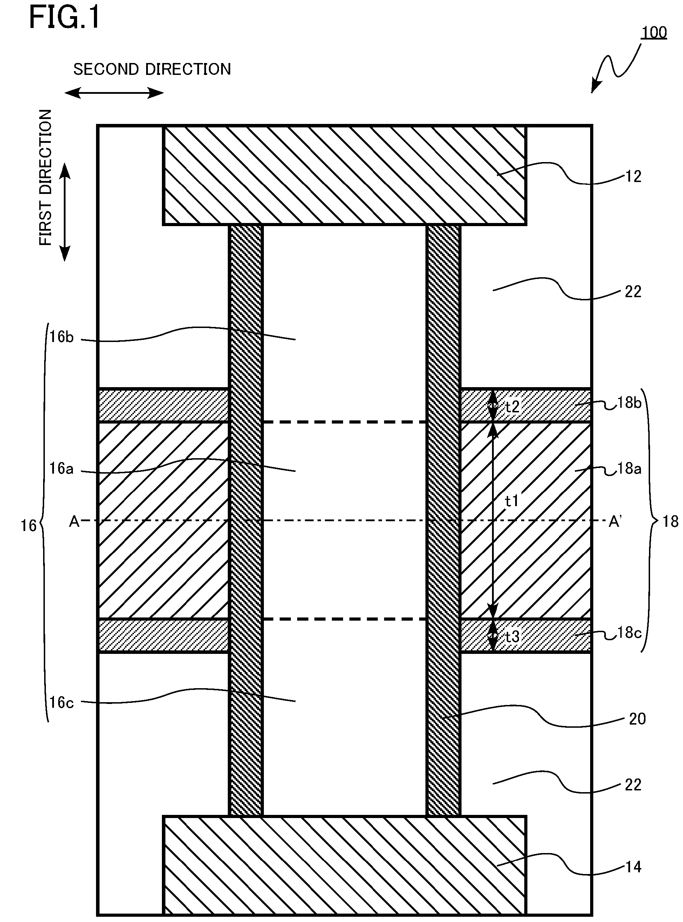

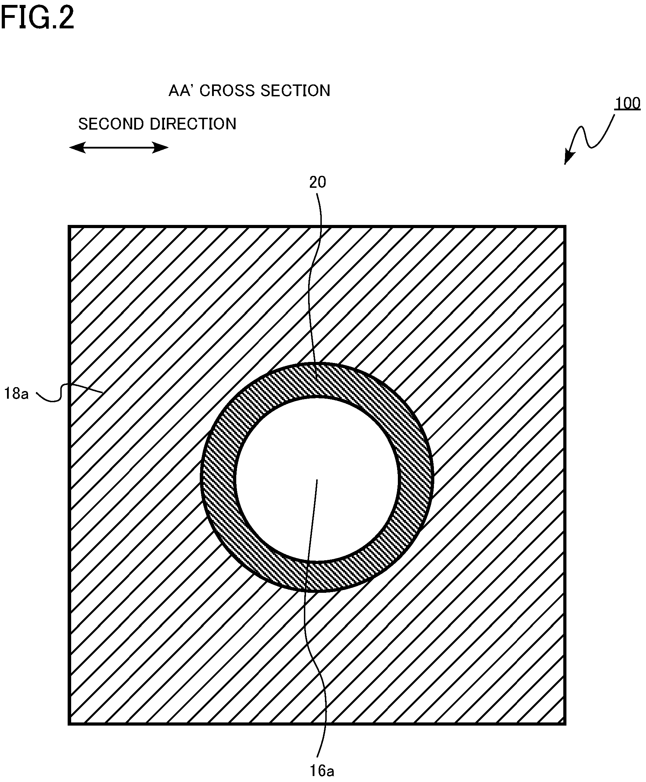

Figs. 1 and 2 are schematic cross-sectional views of the semiconductor device according to the first embodiment. Fig. 2 is a cross-sectional view taken along the line AA' of Fig. 1.

The semiconductor device according to the first embodiment is a transistor 100. The transistor 100 is an oxide semiconductor transistor in which a channel is formed in the oxide semiconductor. In the transistor 100, a gate electrode is provided so as to surround an oxide semiconductor layer in which a channel is formed. The transistor 100 is a so-called GAA (gate all around) transistor. The transistor 100 is a so-called vertical transistor.

Hereinafter, a case where the first conductive type is n-type will be described as an example. The transistor 100 is an n-channel transistor having electrons as carriers.

The transistor 100 includes an upper electrode 12, a lower electrode 14, an oxide semiconductor layer 16, a gate electrode 18, a gate insulating layer 20, and an interlayer insulating layer 22. The oxide semiconductor layer 16 includes a channel region 16a, an upper region 16b, and a lower region 16c. The gate electrode 18 includes an intermediate layer 18a, an upper layer 18b, and a lower layer 18c.

The upper electrode 12 is an example of the first electrode. The lower electrode 14 is an example of the second electrode.

The channel region 16a is an example of the first region. The upper region 16b is an example of the second region. The lower region 16c is an example of the third region.

The intermediate layer 18a is an example of the first layer. The upper layer 18b is an example of the second layer. The lower layer 18c is an example of the third layer.

The upper electrode 12 is provided on the oxide semiconductor layer 16. The upper electrode 12 is electrically connected to the oxide semiconductor layer 16. The upper electrode 12 is in contact with, for example, the oxide semiconductor layer 16. The upper electrode 12 functions as a source electrode or a drain electrode of the transistor 100.

The upper electrode 12 is a conductor. The upper electrode 12 contains, for example, an oxide conductor or a metal.

The lower electrode 14 is provided below the oxide semiconductor layer 16. The lower electrode 14 is electrically connected to the oxide semiconductor layer 16. The lower electrode 14 is in contact with, for example, the oxide semiconductor layer 16. The lower electrode 14 functions as a source electrode or a drain electrode of the transistor 100.

The lower electrode 14 is a conductor. The lower electrode 14 contains, for example, an oxide conductor or a metal.

The oxide semiconductor layer 16 is provided between the upper electrode 12 and the lower electrode 14. The oxide semiconductor layer 16 is in contact with, for example, the upper electrode 12. The oxide semiconductor layer 16 is in contact with, for example, the lower electrode 14.

In the oxide semiconductor layer 16, a channel that serves as a current path when the transistor 100 is turned on is formed.

The oxide semiconductor layer 16 is an oxide semiconductor. The oxide semiconductor layer 16 is, for example, amorphous.

The oxide semiconductor layer 16 contains, for example, zinc (Zn), oxygen (O), and at least one element selected from a group consisting of indium (In), gallium (Ga), silicon (Si), aluminum (Al), and tin (Sn). The oxide semiconductor layer 16 contains, for example, indium (In), gallium (Ga), zinc (Zn), and oxygen (O). The oxide semiconductor layer 16 contains, for example, indium gallium zinc oxide. The oxide semiconductor layer 16 is, for example, an indium gallium zinc oxide layer.

The oxide semiconductor layer 16 contains, for example, oxygen (O) and at least one element selected from a group consisting of titanium (Ti), zinc (Zn), and tungsten (W). The oxide semiconductor layer 16 contains, for example, titanium oxide, zinc oxide, or tungsten oxide. The oxide semiconductor layer 16 is, for example, a titanium oxide layer, a zinc oxide layer, or a tungsten oxide layer.

The oxide semiconductor layer 16 is an n-type oxide semiconductor. The oxide semiconductor layer 16 includes, for example, oxygen vacancies. The oxygen vacancies in the oxide semiconductor layer 16 function as donors.

The length of the oxide semiconductor layer 16 in the first direction is, for example, equal to or more than 50 nm and equal to or less than 200 nm. The length of the oxide semiconductor layer 16 in the second direction is, for example, equal to or more than 10 nm and equal to or less than 50 nm.

The first direction is a direction connecting the upper electrode 12 and the lower electrode 14. The second direction is perpendicular to the first direction.

The oxide semiconductor layer 16 includes an n-type channel region 16a, an n-type upper region 16b, and an n-type lower region 16c. The channel region 16a, the upper region 16b, and the lower region 16c are formed of an n-type oxide semiconductor.

The channel region 16a is provided so as to face the gate electrode 18. The channel region 16a is spaced from the upper electrode 12 and the lower electrode 14. The channel region 16a is a region where a channel through which electrons flow is formed when the transistor 100 is in an on state.

The upper region 16b is provided between the channel region 16a and the upper electrode 12. The upper region 16b is in contact with the channel region 16a. The upper region 16b is in contact with the upper electrode 12. The upper region 16b functions as a source region or a drain region of the transistor 100.

The lower region 16c is provided between the channel region 16a and the lower electrode 14. The lower region 16c is in contact with the channel region 16a. The lower region 16c is in contact with the lower electrode 14. The lower region 16c functions as a source region or a drain region of the transistor 100.

The gate electrode 18 faces the oxide semiconductor layer 16. The gate electrode 18 is provided so that its position coordinates in the first direction are a value between the position coordinates of the upper electrode 12 and the position coordinates of the lower electrode 14 in the first direction.

As shown in Fig. 2, the gate electrode 18 surrounds the oxide semiconductor layer 16 in a cross section perpendicular to the first direction. The gate electrode 18 is provided around the oxide semiconductor layer 16.

The gate electrode 18 is a conductor. The gate electrode 18 contains, for example, a metal, a metal compound, or a semiconductor. The gate electrode 18 is formed of, for example, a metal, a metal compound, or a semiconductor.

The thickness of the gate electrode 18 in the first direction is, for example, equal to or more than 30 nm and equal to or less than 100 nm.

The gate electrode 18 includes the intermediate layer 18a, the upper layer 18b, and the lower layer 18c.

The intermediate layer 18a faces the channel region 16a. The intermediate layer 18a is in contact with the gate insulating layer 20.

The intermediate layer 18a contains a first material. The intermediate layer 18a is formed of, for example, the first material. The first material has a first work function.

The first material is a conductor. The first material is, for example, a metal, a metal compound, or a semiconductor.

The first material is, for example, titanium (Ti), tungsten (W), molybdenum (Mo), tantalum (Ta), ruthenium (Ru), nickel (Ni), cobalt (Co), titanium nitride, tungsten nitride, molybdenum nitride, tantalum nitride, indium tin oxide, tin oxide, zinc oxide, indium oxide, indium zinc oxide, indium gallium zinc oxide, n-type polycrystalline silicon, or p-type polycrystalline silicon.

The first thickness (t1 in Fig. 1) of the intermediate layer 18a in the first direction is, for example, equal to or more than 20 nm and equal to or less than 80 nm.

The upper layer 18b is provided on the upper electrode 12 side with respect to the intermediate layer 18a. The upper layer 18b is in contact with, for example, the intermediate layer 18a. The upper layer 18b is in contact with, for example, the gate insulating layer 20.

The upper layer 18b contains a second material. The upper layer 18b is formed of, for example, the second material. The second material has a second work function.

The second work function is smaller than the first work function. The difference between the second work function and the first work function is, for example, equal to or more than 0.2 eV and equal to or less than 1.0 eV.

The work function of the upper layer 18b is lower than the work function of the intermediate layer 18a because the upper layer 18b contains the second material having a second work function smaller than the first work function.

The second material is, for example, different from the first material. The chemical composition of the second material is, for example, different from the chemical composition of the first material.

The second material is a conductor. The second material is, for example, a metal, a metal compound, or a semiconductor.

The second material is, for example, titanium (Ti), tungsten (W), molybdenum (Mo), tantalum (Ta), titanium nitride, tungsten nitride, molybdenum nitride, tantalum nitride, indium tin oxide, tin oxide, zinc oxide, n-type polycrystalline silicon, or p-type polycrystalline silicon.

For example, when the first material is tungsten and the second material is a titanium nitride, the second work function can be made smaller than the first work function. In addition, for example, when the first material is tungsten and the second material is a tungsten nitride, the second work function can be made smaller than the first work function. In addition, for example, when the first material is an indium tin oxide and the second material is an indium gallium oxide, the second work function can be made smaller than the first work function. In addition, for example, when the first material is an indium tin oxide and the second material is an indium gallium zinc oxide, the second work function can be made smaller than the first work function.

The second thickness (t2 in Fig. 1) of the upper layer 18b in the first direction is, for example, smaller than the first thickness t1 of the intermediate layer 18a. The second thickness t2 of the upper layer 18b in the first direction is, for example, equal to or more than 1/100 and equal to or less than 1/5 of the first thickness t1 of the intermediate layer 18a. The second thickness t2 of the upper layer 18b in the first direction is, for example, equal to or more than 1 nm and equal to or less than 10 nm.

The lower layer 18c is provided on the lower electrode 14 side with respect to the intermediate layer 18a. The lower layer 18c is in contact with, for example, the intermediate layer 18a. The lower layer 18c is in contact with, for example, the gate insulating layer 20.

The lower layer 18c contains a third material. The lower layer 18c is formed of, for example, the third material. The third material has a third work function.

The third work function is smaller than the first work function. The difference between the third work function and the first work function is, for example, equal to or more than 0.2 eV and equal to or less than 1.0 eV.

The work function of the lower layer 18c is lower than the work function of the intermediate layer 18a because the lower layer 18c contains the third material having a third work function smaller than the first work function.

The third material is, for example, different from the first material. The chemical composition of the third material is, for example, different from the chemical composition of the first material.

The third material is, for example, the same as the second material. The chemical composition of the third material is, for example, the same as the chemical composition of the second material.

The third material is a conductor. The third material is, for example, a metal, a metal compound, or a semiconductor.

The third material is, for example, titanium (Ti), tungsten (W), molybdenum (Mo), tantalum (Ta), titanium nitride, tungsten nitride, molybdenum nitride, tantalum nitride, indium tin oxide, tin oxide, zinc oxide, n-type polycrystalline silicon, or p-type polycrystalline silicon.

For example, when the first material is tungsten and the third material is a titanium nitride, the third work function can be made smaller than the first work function. In addition, for example, when the first material is tungsten and the third material is a tungsten nitride, the third work function can be made smaller than the first work function.

The third thickness (t3 in Fig. 1) of the lower layer 18c in the first direction is, for example, smaller than the first thickness t1 of the intermediate layer 18a. The third thickness t3 of the lower layer 18c in the first direction is, for example, equal to or more than 1/100 and equal to or less than 1/5 of the first thickness t1 of the intermediate layer 18a. The third thickness t3 of the lower layer 18c in the first direction is, for example, equal to or more than 1 nm and equal to or less than 10 nm.

The gate insulating layer 20 is provided between the oxide semiconductor layer 16 and the gate electrode 18. As shown in Fig. 2, the gate insulating layer 20 surrounds the oxide semiconductor layer 16 in a cross section perpendicular to the first direction. The gate insulating layer 20 is provided between the upper electrode 12 and the lower electrode 14. The gate insulating layer 20 is in contact with, for example, the upper electrode 12 and the lower electrode 14.

The gate insulating layer 20 contains, for example, silicon (Si) and nitrogen (N). The gate insulating layer 20 contains, for example, silicon nitride.

The gate insulating layer 20 contains, for example, silicon (Si) and oxygen (O). The gate insulating layer 20 contains, for example, silicon oxide.

The gate insulating layer 20 is, for example, a stacked film of a silicon oxide film and a silicon nitride film. When the gate insulating layer 20 is a stacked film of a silicon oxide film and a silicon nitride film, the silicon oxide film is provided, for example, between the silicon nitride film and the oxide semiconductor layer 16.

The thickness of the gate insulating layer 20 is, for example, equal to or more than 2 nm and equal to or less than 10 nm.

The interlayer insulating layer 22 surrounds, for example, the upper electrode 12, the lower electrode 14, the oxide semiconductor layer 16, and the gate insulating layer 20. The interlayer insulating layer 22 is provided, for example, between the upper electrode 12 and the gate electrode 18. The interlayer insulating layer 22 is provided, for example, between the lower electrode 14 and the gate electrode 18.

The interlayer insulating layer 22 is an insulator. The interlayer insulating layer 22 is, for example, an oxide, a nitride, or an oxynitride. The interlayer insulating layer 22 contains, for example, silicon (Si) and oxygen (O). The interlayer insulating layer 22 contains, for example, silicon oxide. The interlayer insulating layer 22 is, for example, a silicon oxide.

Next, the function and effect of the semiconductor device according to the first embodiment will be described.

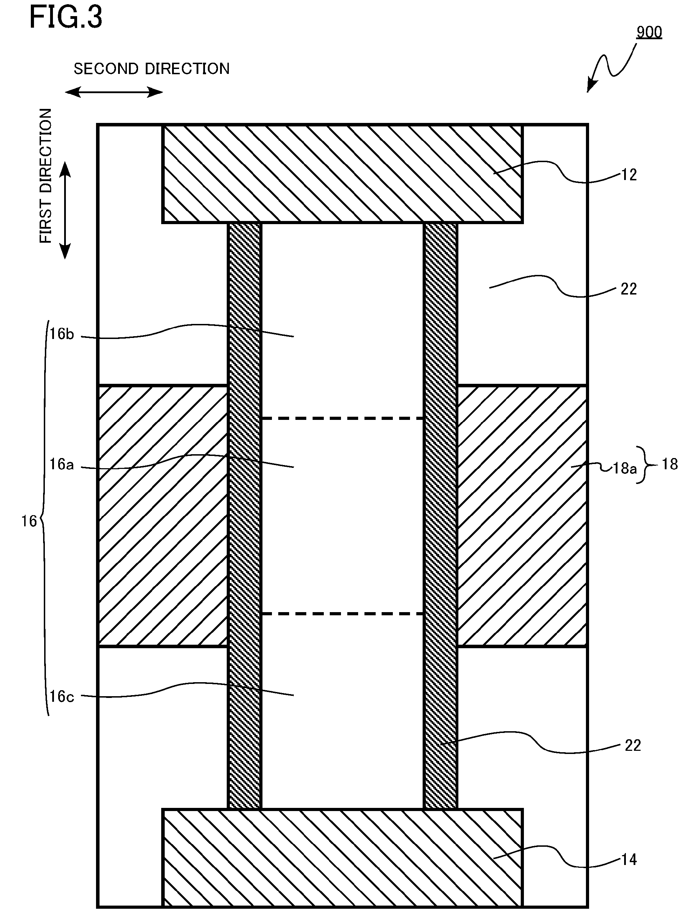

Fig. 3 is a schematic cross-sectional view of a semiconductor device according to a comparative embodiment. Fig. 3 is a diagram corresponding to Fig. 1 in the first embodiment.

The semiconductor device according to the comparative embodiment is a transistor 900. The transistor 900 according to the comparative embodiment is different from the transistor 100 according to the first embodiment in that the gate electrode 18 does not include the upper layer 18b and the lower layer 18c.

The transistor 900 according to the comparative embodiment has a problem in that the on-current is small due to high parasitic resistance in the upper region 16b and the lower region 16c of the oxide semiconductor layer 16 when the transistor 900 is in an on state.

In the transistor 100 according to the first embodiment, the gate electrode 18 includes the upper layer 18b and the lower layer 18c. The work functions of the upper layer 18b and the lower layer 18c are smaller than the work function of the intermediate layer 18a.

For this reason, when the transistor 100 is in an on state, the electric field applied to the upper region 16b and the lower region 16c by the gate electrode 18 increases. Therefore, more electrons are induced in the upper region 16b and the lower region 16c of the oxide semiconductor layer 16 than in the transistor 900 according to the comparative embodiment. Therefore, the parasitic resistance of the upper region 16b and the lower region 16c is lower than that in the transistor 900 according to the comparative embodiment. As a result, the on-current of the transistor 100 according to the first embodiment is larger than that of the transistor 900 according to the comparative embodiment.

### (Further Embodiment)

A semiconductor device according to a further embodiment of the first embodiment is different from the semiconductor device according to the first embodiment in that the gate electrode further includes a fourth layer, which is provided between the first layer and the second layer and has a fourth work function different from the first work function and the second work function, and a fifth layer, which is provided between the first layer and the third layer and has a fifth work function different from the first work function and the third work function.

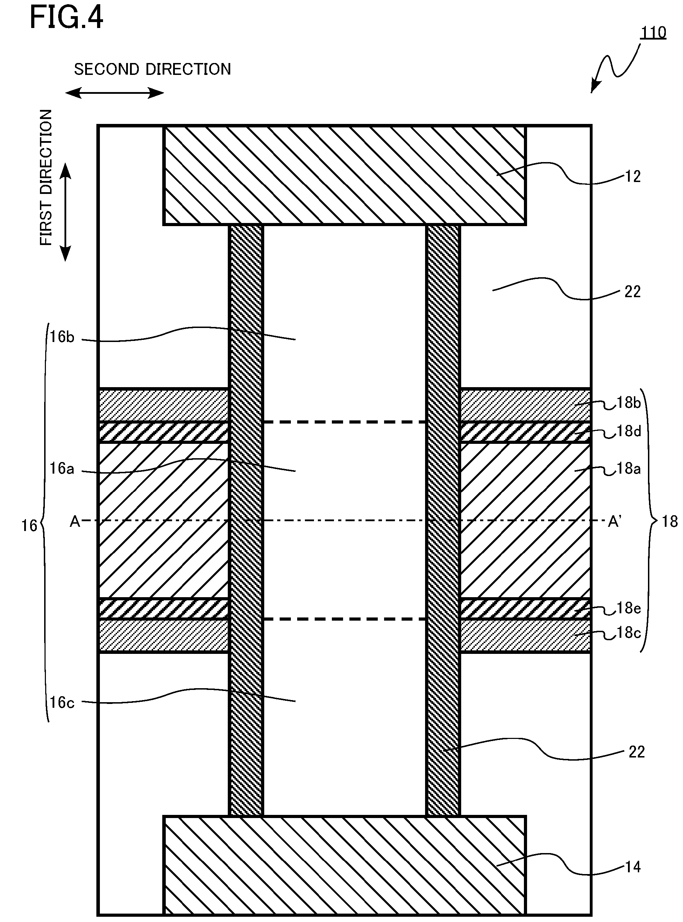

Fig. 4 is a schematic cross-sectional view of the semiconductor device according to the further embodiment of the first embodiment. Fig. 4 is a diagram corresponding to Fig. 1 in the first embodiment. The semiconductor device according to the further embodiment of the first embodiment is a transistor 110.

The gate electrode 18 of the transistor 110 includes an intermediate layer 18a, an upper layer 18b, a lower layer 18c, an upper additional layer 18d, and a lower additional layer 18e.

The intermediate layer 18a is an example of the first layer. The upper layer 18b is an example of the second layer. The lower layer 18c is an example of the third layer. The upper additional layer 18d is an example of the fourth layer. The lower additional layer 18e is an example of the fifth layer.

The upper additional layer 18d is provided between the intermediate layer 18a and the upper layer 18b. The upper additional layer 18d is in contact with, for example, the intermediate layer 18a. The upper additional layer 18d is in contact with, for example, the upper layer 18b.

The upper additional layer 18d contains a fourth material. The upper additional layer 18d is formed of, for example, the fourth material. The fourth material has a fourth work function.

The fourth work function is different from the first work function and the second work function. The fourth work function is larger or smaller than the first work function. The fourth work function is larger or smaller than the second work function.

The work function of the upper additional layer 18d is different from the work functions of the intermediate layer 18a and the upper layer 18b because the upper additional layer 18d contains the fourth material having a fourth work function different from the first work function and the second work function.

The fourth material is, for example, different from the first material and the second material.

The fourth material is a conductor. The fourth material is, for example, a metal, a metal compound, or a semiconductor.

The lower additional layer 18e is provided between the intermediate layer 18a and the lower layer 18c. The lower additional layer 18e is in contact with, for example, the intermediate layer 18a. The lower additional layer 18e is in contact with, for example, the lower layer 18c.

The lower additional layer 18e contains a fifth material. The lower additional layer 18e is formed of, for example, the fifth material. The fifth material has a fifth work function.

The fifth work function is different from the first work function and the third work function. The fifth work function is larger or smaller than the first work function. The fifth work function is larger or smaller than the third work function.

The work function of the lower additional layer 18e is different from the work functions of the intermediate layer 18a and the lower layer 18c because the lower additional layer 18e contains the fifth material having a fifth work function different from the first work function and the third work function.

The fifth material is, for example, different from the first material and the third material.

The fifth material is a conductor. The fifth material is, for example, a metal, a metal compound, or a semiconductor.

In the transistor 110 according to the further embodiment of the first embodiment, since the gate electrode 18 includes the upper layer 18b and the lower layer 18c, the on-current of the transistor increases as in the first embodiment.

As described above, according to the first embodiment and its further embodiment, it is possible to realize a semiconductor device with a large on-current and excellent transistor characteristics.

### (Second Embodiment)

A semiconductor memory device according to a second embodiment includes the semiconductor device according to the first embodiment and a capacitor electrically connected to the first electrode or the second electrode.

The semiconductor memory device according to the second embodiment is a semiconductor memory 200. The semiconductor memory device according to the second embodiment is a DRAM. In the semiconductor memory 200, the transistor 100 according to the first embodiment is used as a switching transistor of a memory cell in a DRAM.

Hereinafter, the description of a part of the content overlapping the first embodiment will be omitted.

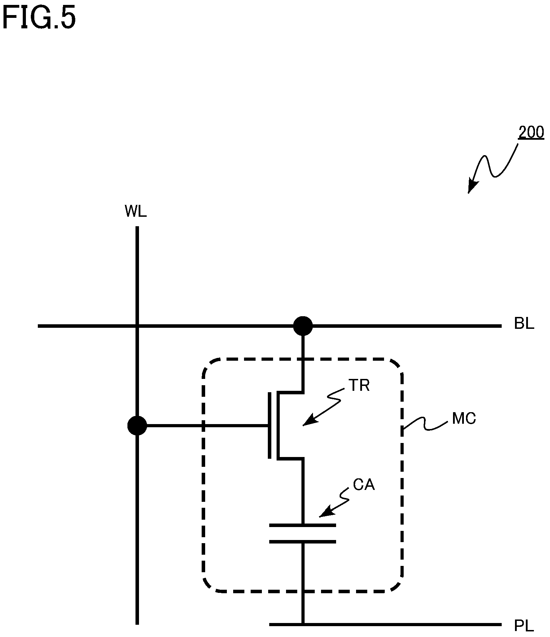

Fig. 5 is an equivalent circuit diagram of the semiconductor memory device according to the second embodiment. Fig. 5 illustrates a case where one memory cell MC is provided. However, for example, a plurality of memory cells MC may be provided in an array.

The semiconductor memory 200 includes the memory cell MC, a word line WL, a bit line BL, and a plate line PL. The memory cell MC includes a switching transistor TR and a capacitor CA. In Fig. 5, a region surrounded by the broken line is the memory cell MC.

The word line WL is electrically connected to the gate electrode of the switching transistor TR. The bit line BL is electrically connected to one of the source electrode and the drain electrode of the switching transistor TR. One electrode of the capacitor CA is electrically connected to the other one of the source electrode and the drain electrode of the switching transistor TR. The other electrode of the capacitor CA is connected to the plate line PL.

The memory cell MC stores data by storing charges in the capacitor CA. Data is written and read by turning on the switching transistor TR.

For example, data is written into the memory cell MC by turning on the switching transistor TR in a state in which a desired voltage is applied to the bit line BL.

In addition, for example, a voltage change in the bit line BL according to the amount of charge stored in the capacitor is detected by turning on the switching transistor TR, thereby reading the data of the memory cell MC.

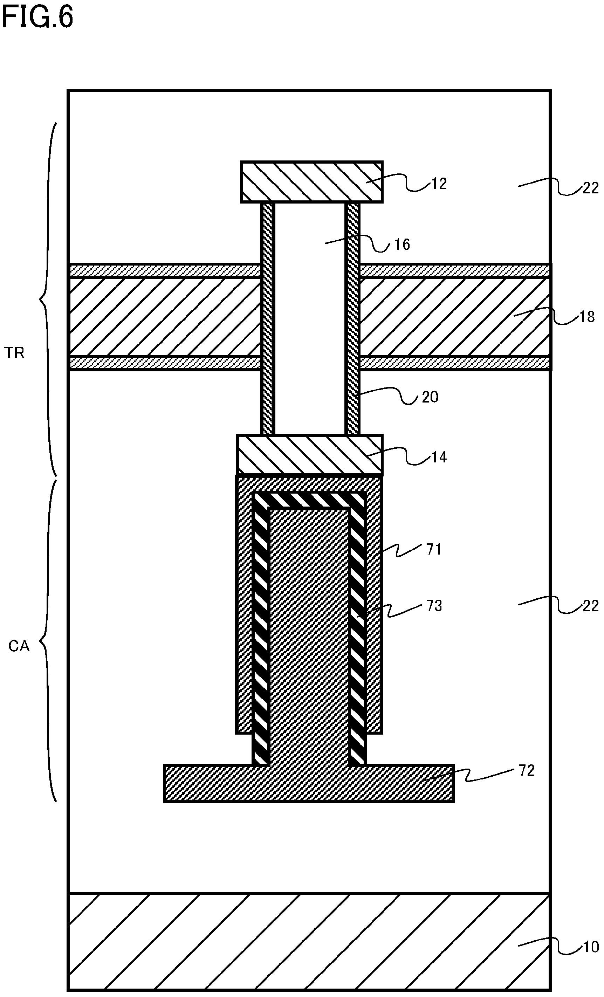

Fig. 6 is a schematic cross-sectional view of the semiconductor memory device according to the second embodiment. Fig. 6 shows a cross section of the memory cell MC of the semiconductor memory 200.

The semiconductor memory 200 includes a silicon substrate 10, a switching transistor TR, and a capacitor CA.

The switching transistor TR has a structure similar to that of the transistor 100 according to the first embodiment.

The capacitor CA is provided between the silicon substrate 10 and the switching transistor TR. The capacitor CA is provided between the silicon substrate 10 and the lower electrode 14. The capacitor CA is electrically connected to the lower electrode 14.

The capacitor CA includes a cell electrode 71, a plate electrode 72, and a capacitor insulating film 73. The cell electrode 71 is electrically connected to the lower electrode 14.

Each of the cell electrode 71 and the plate electrode 72 is, for example, a titanium nitride. The capacitor insulating film 73 has, for example, a stacked structure of a zirconium oxide, an aluminum oxide, and a zirconium oxide.

The gate electrode 18 is electrically connected to, for example, the word line WL (not shown). The upper electrode 12 is electrically connected to, for example, the bit line BL (not shown). The plate electrode 72 is connected to, for example, the plate line PL (not shown).

In the semiconductor memory 200, an oxide semiconductor transistor having a very small channel leakage current during off operation is applied as the switching transistor TR. Therefore, a DRAM having an excellent charge storage characteristic is realized.

In addition, the switching transistor TR of the semiconductor memory 200 is the transistor 100 with excellent characteristics in the first embodiment. Therefore, the semiconductor memory 200 with excellent operating characteristics can be realized.

In the second embodiment, a semiconductor memory to which the transistor according to the first embodiment is applied has been described as an example. However, the semiconductor memory of embodiments may be a semiconductor memory to which the transistor according to the further embodiment of the first embodiment is applied.

In the first embodiment, the case where the first conductive type is n-type has been described as an example. However, the first conductive type may be p-type. When the first conductive type is p-type, the second work function is larger than the first work function, and the third work function is larger than the first work function.

In the first embodiment, the case where the gate electrode 18 has a three-layer structure has been described as an example, and in the further embodiment of the first embodiment, the case where the gate electrode 18 has a five-layer structure has been described as an example. However, the gate electrode 18 may have a four-layer structure or a six-layer or more structure.

In the first embodiment, the case where the second material and the third material are the same has been described as an example. However, the second material and the third material may be different.

In the second embodiment, the case where the capacitor CA is electrically connected to the lower electrode 14 has been described as an example. However, the capacitor CA may be electrically connected to the upper electrode 12.

Technical aspects of the inventions will be described below. The technical aspects described below are within the scope of the inventions.
Clause 1. A semiconductor device, comprising:
   a first electrode;
   a second electrode;
   an oxide semiconductor layer provided between the first electrode and the second electrode;
   a gate electrode surrounding the oxide semiconductor layer; and
   a gate insulating layer provided between the gate electrode and the oxide semiconductor layer,
   wherein the oxide semiconductor layer includes:
      a first region of a first conductive type facing the gate electrode;
      a second region of the first conductive type provided between the first region and the first electrode; and
      a third region of the first conductive type provided between the first region and the second electrode,
      the gate electrode includes:
         a first layer containing a first material having a first work function;
         a second layer provided on a first electrode side with respect to the first layer and containing a second material having a second work function; and
         a third layer provided on a second electrode side with respect to the first layer and containing a third material having a third work function,
         when the first conductive type is n-type, the second work function is smaller than the first work function, and the third work function is smaller than the first work function, and
         when the first conductive type is p-type, the second work function is larger than the first work function, and the third work function is larger than the first work function.
Clause 2. The semiconductor device according to clause 1,
   wherein the second material is different from the first material, the third material is different from the first material, and the second material and the third material are the same.
Clause 3. The semiconductor device according to clause 1 or 2,
   wherein the second layer is in contact with the first layer, and the third layer is in contact with the first layer.
Clause 4. The semiconductor device according to any preceding clause,
   wherein the first layer faces the first region.
Clause 5. The semiconductor device according to any preceding clause,
   wherein the first layer is in contact with the gate insulating layer.
Clause 6. The semiconductor device according to any preceding clause,
   wherein a second thickness of the second layer in a first direction from the first electrode to the second electrode is smaller than a first thickness of the first layer in the first direction, and
   a third thickness of the third layer in the first direction is smaller than the first thickness.
Clause 7. The semiconductor device according to clause 6,
   wherein the second thickness is equal to or less than 1/5 of the first thickness, and the third thickness is equal to or less than 1/5 of the first thickness.
Clause 8. The semiconductor device according to clause 6 or 7,
   wherein the second thickness is equal to or less than 10 nm, and the third thickness is equal to or less than 10 nm.
Clause 9. The semiconductor device according to any preceding clause,
   wherein, when the first conductive type is n-type, the first material is tungsten, the second material is a titanium nitride or a tungsten nitride, and the third material is a titanium nitride or a tungsten nitride.
Clause 10. The semiconductor device according to any preceding clause,
   wherein the second region is in contact with the first region and the first electrode, and
   the third region is in contact with the first region and the second electrode.
Clause 11. A semiconductor memory device, comprising:
   the semiconductor device according to any preceding clause; and
   a capacitor electrically connected to either the first electrode or the second electrode.

While certain embodiments have been described, these embodiments have been presented by way of example only, and are not intended to limit the scope of the inventions. Indeed, the semiconductor device and the semiconductor memory device described herein may be embodied in a variety of other forms; furthermore, various omissions, substitutions and changes in the form of the devices and methods described herein may be made without departing from the scope of the inventions. The accompanying claims are intended to cover such forms or modifications as would fall within the scope of the inventions.

## Claims

1. A semiconductor device (100), comprising:
a first electrode (12);
a second electrode (14);
an oxide semiconductor layer (16) provided between the first electrode (12) and the second electrode (14);
a gate electrode (18) surrounding the oxide semiconductor layer (16); and
a gate insulating layer (20) provided between the gate electrode (18) and the oxide semiconductor layer (16),
wherein the oxide semiconductor layer (16) includes:
a first region (16a) of a first conductive type facing the gate electrode (18);
a second region (16b) of the first conductive type provided between the first region (16a) and the first electrode (12); and
a third region (16c) of the first conductive type provided between the first region (16a) and the second electrode (14),
the gate electrode (18) includes:
a first layer (18a) containing a first material having a first work function;
a second layer (18b) provided on a first electrode side with respect to the first layer (18a) and containing a second material having a second work function; and
a third layer (18c) provided on a second electrode side with respect to the first layer (18a) and containing a third material having a third work function,
when the first conductive type is n-type, the second work function is smaller than the first work function, and the third work function is smaller than the first work function, and
when the first conductive type is p-type, the second work function is larger than the first work function, and the third work function is larger than the first work function.

2. The semiconductor device (100) according to claim 1,
wherein the second material is different from the first material, the third material is different from the first material, and the second material and the third material are the same.

3. The semiconductor device (100) according to claim 1 or 2,
wherein the second layer (18b) is in contact with the first layer (18a), and the third layer (18c) is in contact with the first layer (18a).

4. The semiconductor device (100) according to any preceding claim,
wherein the first layer faces the first region.

5. The semiconductor device according to any preceding claim,
wherein the first layer (18a) is in contact with the gate insulating layer (20).

6. The semiconductor device (100) according to any preceding claim,
wherein a second thickness of the second layer (18b) in a first direction from the first electrode (12) to the second electrode (14) is smaller than a first thickness of the first layer (18a) in the first direction, and
a third thickness of the third layer (18c) in the first direction is smaller than the first thickness.

7. The semiconductor device (100) according to claim 6,
wherein the second thickness is equal to or less than 1/5 of the first thickness, and the third thickness is equal to or less than 1/5 of the first thickness.

8. The semiconductor device (100) according to claim 6 or 7,
wherein the second thickness is equal to or less than 10 nm, and the third thickness is equal to or less than 10 nm.

9. The semiconductor device (100) according to any preceding claim,
wherein, when the first conductive type is n-type, the first material is tungsten, the second material is a titanium nitride or a tungsten nitride, and the third material is a titanium nitride or a tungsten nitride.

10. The semiconductor device (100) according to any preceding claim,
wherein the second region (16b) is in contact with the first region (16a) and the first electrode (12), and
the third region (16c) is in contact with the first region (16a) and the second electrode (14).

11. A semiconductor memory device (200), comprising:
the semiconductor device (100) according to any preceding claim; and
a capacitor electrically connected to either the first electrode (12) or the second electrode (14).
